# EUROPEAN PATENT APPLICATION

(11) **EP 3 930 192 A1**
(43) Date of publication of application: **29.12.2021**
(21) Application number: 21181754.9
(22) Date of filing: 25.06.2021
(51) Int. Cl.: H03K 17/082, H03K 17/18

(54) **POWER SWITCH SHORT CIRCUIT PROTECTION**

(30) Priority: 26.06.2020 US 202016912775
(71) Applicant: ABB SCHWEIZ AG, 5400 Baden (CH)
(72) Inventor: LIU, Liming, Cary, 27519 (US); XU, Jing, Cary, 27519 (US); PAN, Zhiguo, Cary, 27519 (US)
(74) Representative: Gunzelmann, Rainer

(57) **Abstract**

Systems, methods, techniques and apparatuses of power switch protection are disclosed. One exemplary embodiment is a protection system for a power switch comprising a resistor and a detection circuit. The resistor is coupled in series with a decoupling capacitor. The detection circuit is structured to receive a voltage of the resistor, determine a short circuit is occurring based on the received electrical characteristic, and transmit a fault trigger signal in response to determining the short circuit is occurring.

## Description

### BACKGROUND

The present disclosure relates generally to power switch protection. Some recently developed types of semiconductor switches fail quickly when conducting short circuit current. For example, some wide-bandgap switches may fail after conducting short circuit current for as little as 600ns. Existing power switch protection systems suffer from a number of shortcomings and disadvantages. There remain unmet needs including increasing protection system responsiveness and reducing protection system power losses. For instance, some conventional protection systems, such as desaturation detection-based systems, do not respond quickly enough to protect wide-bandgap switches from short circuit current. Furthermore, some conventional protection systems monitor a shunt resistor inserted into the load current path, generating constant power losses. In view of these and other shortcomings in the art, there is a significant need for the apparatuses, methods, systems and techniques disclosed herein.

### DISCLOSURE OF ILLUSTRATIVE EMBODIMENTS

For the purposes of clearly, concisely and exactly describing non-limiting exemplary embodiments of the disclosure, the manner and process of making and using the same, and to enable the practice, making and use of the same, reference will now be made to certain exemplary embodiments, including those illustrated in the figures, and specific language will be used to describe the same. It shall nevertheless be understood that no limitation of the scope of the present disclosure is thereby created, and that the present disclosure includes and protects such alterations, modifications, and further applications of the exemplary embodiments as would occur to one skilled in the art with the benefit of the present disclosure.

### SUMMARY OF THE DISCLOSURE

Exemplary embodiments of the disclosure include systems, methods, techniques and apparatuses for power switch short circuit protection. Further embodiments, forms, objects, features, advantages, aspects and benefits of the disclosure shall become apparent from the following description and drawings.

### BRIEF DESCRIPTION OF THE DRAWINGS

Fig. 1 illustrates an exemplary power switch protection system.
Fig. 2 illustrates an exemplary detection circuit.
Fig. 3 illustrates an exemplary gate driver circuit.
Fig. 4 is a plurality of graphs illustrating short circuit protection using the exemplary power switch protection system of Fig. 1.

### DETAILED DESCRIPTION of illustrative embodiments

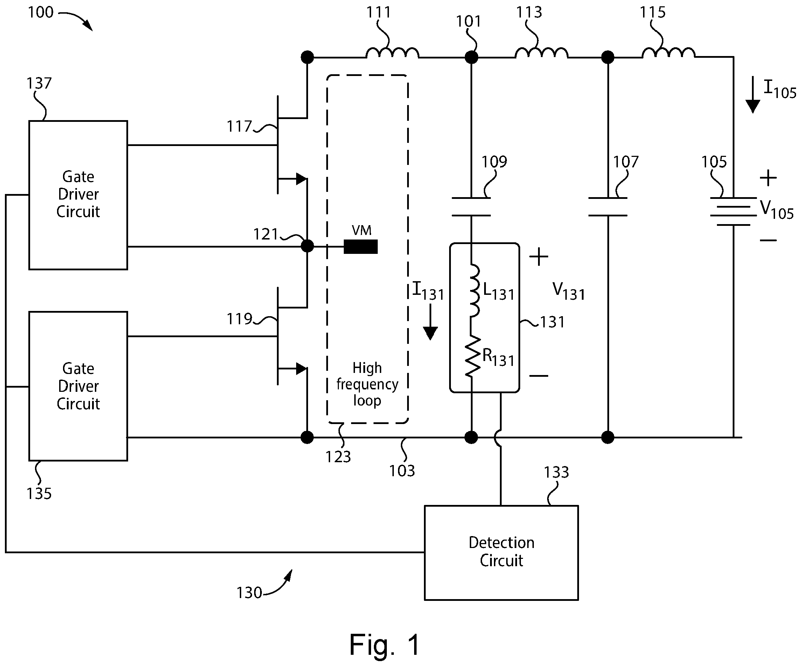

With reference to Fig. 1, there is illustrated an exemplary power system 100 including a power switch protection system 130. It shall be appreciated that system 130 may be implemented in a variety of applications, including bi-level and multi-level power converters, to name but a few examples. It shall be also appreciated that the topology of system 100 is illustrated for the purpose of explanation and is not intended as a limitation of the present disclosure unless otherwise specified.

Power system 100 is structured to transmit power between an output terminal 121 and a power device 105. System 100 may be structured to transmit power unidirectionally from power device 105 to output terminal 121, transmit power unidirectionally from output terminal 121 to power device 105, or transmit power bi-directionally between output terminal 121 and power device 105. Output terminal 121 may receive or transmit alternating current (AC) or direct current (DC) power. Power device 105 is structured to transmit or receive DC power.

Power system 100 includes a DC bus including a DC bus rail 101 and a DC bus rail 103. Four legs are coupled across the DC bus. Between the first leg and the second leg, the DC bus has a parasitic inductance 111. Between the second leg and third leg, the DC bus has a parasitic inductance 113. Between the third leg and the fourth leg, the DC bus has a parasitic inductance 115.

The first leg includes a power switch 117 and a power switch 119 structured to convert or transmit power between output terminal 121 and power device 105. For example, power switch 117 and power switch 119 may convert AC power received from output terminal 121 into DC power, or convert DC power received from the DC bus into AC power. Power switch 117 is coupled between DC bus rail 101 and output terminal 121, and power switch 119 is coupled between DC bus rail 103 and output terminal 121. Each power switch 117, 119 may include a wide-bandgap switch, such as an E-mode gallium nitride (GaN) switch, a cascode-mode GAN switch, or a silicon carbide switch, to name but a few examples.

The second leg includes a decoupling capacitor 109 and a resistor 131 coupled in series between DC bus rail 101 and DC bus rail 103. Decoupling capacitor 109 is structured to reduce electric noise generated by operation of power switches 117 and 119. In certain embodiments, decoupling capacitor 109 may be a ceramic capacitor or a film capacitor. In certain embodiments, the capacitance of decoupling capacitor may be between 100nF to 1uF, or may be 10-100 times the output capacitance of power switches 117 and 119.

Resistor 131 may include an external resistor or an equivalent resistor. For example, resistor 131 may include an external resistor having a resistance or a printed circuit board trace arrangement having an equivalent resistance. Resistor 131 is structured to have a small resistance R₁₃₁. For example, the resistance or equivalent resistance of resistor 131 may be between 200 microohms and 10 milliohms, or between 200 microohms and 800 microohms, to give but a few examples.

The components of the first leg and the second leg form a high frequency loop 123 such that only transient current, such as noise from the operation of the power switches, flow through the second leg, including resistor 131. Therefore, power losses from resistor 131 of the second leg are negligible compared to placing a resistor with the same resistance in the current path of load current I₁₀₅. By placing resistor 131 in high frequency loop 123, resistor 131 induces an inductance L₁₃₁. In certain embodiments, resistor 131 is located within 10mm of power switch 119.

The third leg includes a DC link capacitor 107 coupled between DC bus rail 101 and DC bus rail 103. In certain embodiments, DC link capacitor 107 includes a capacitance greater than the capacitance of the decoupling capacitor. For example, the capacitance of DC link capacitor 107 may be 100 times greater than the capacitance of decoupling capacitor 109. DC link capacitor 107 is also placed farther away from switches 117 and 119 compared the decoupling capacitor 109. For example, decoupling capacitor may be placed less than 10mm from power switches 117 and 119 while the DC link capacitor may be placed several centimeters away.

The fourth leg includes a power device 105 coupled between DC bus rail 101 and DC bus rail 103. In the illustrated embodiment, power device 105 is an energy storage device structured to receive power from the DC bus, store energy, and provide power to the DC bus. Power device 105 may also be a power generation device, or another type of device structured to receive or transmit DC power.

Power switch protection system 130 is structured to protect power system 100 from short circuits occurring within power system 100. For example, system 130 may protect system 100 from phase-leg short circuits or phase-to-phase short circuits. Power switch protection system 130 includes resistor 131, a detection circuit 133, and gate driver circuits 135 and 137.

Detection circuit 133 is structured to measure a voltage V₁₃₁ across resistor 131. When current flows through high frequency loop 123, the current causes voltage V₁₃₁ across resistor 131. During normal operation, transient current generated by power switch toggling flows through resistor 131 due to decoupling capacitor 109 absorbing changes in voltage caused by the toggling. While the power switch toggling may cause voltage oscillation in the DC bus, detection circuit 133 determines the voltage V₁₃₁ across resistor 131 remains below a short circuit threshold. Once a short circuit occurs, short circuit current flows through high frequency loop 123, causing detection circuit 133 to determine voltage V₁₃₁ across resistor 131 exceeds the short circuit threshold.

The short circuit threshold is a voltage greater than the voltage across resistor 131 generated by power switch toggling. In certain embodiments, the short circuit threshold is 3-5 times the peak nominal voltage across the resistor caused by power switch toggling. In certain embodiments, detection circuit 133 determines a short circuit is occurring within 50ns of the beginning of the short circuit.

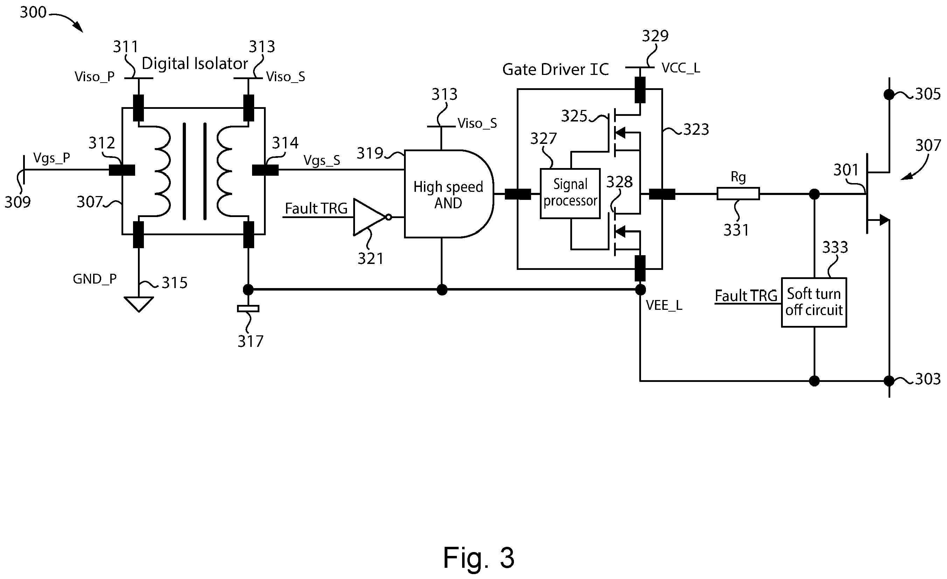

Gate driver circuit 135 is structured to operate power switch 119 and gate driver circuit 137 is structured to operate power switch 117. As described in more detail below with respect to gate driver circuit 300 of Fig. 3, gate driver circuits 135 and 137 are structured to receive a fault trigger signal from detection circuit 133 and, in response to receiving a fault trigger signal indicating a short circuit is occurring, turn off power switches 117 and 119. In certain embodiments, each gate driver circuit is structured to turn off its corresponding power switch within 600ns of the beginning of the short circuit. For example, each gate driver circuit may turn off its corresponding power switch within 150ns of receiving the fault trigger signal so as to turn off the corresponding power switch within 200ns of the short circuit fault beginning. It shall be appreciated that any or all of the foregoing features of the components of power system 100 may also be present in the other components disclosed herein.

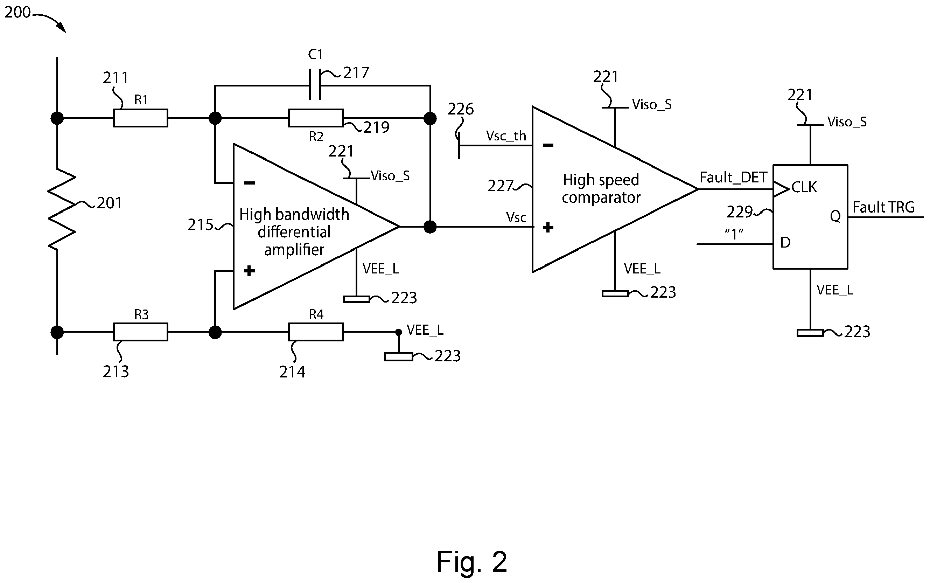

With reference to Fig. 2, there is a circuit diagram illustrating an exemplary detection circuit 200, such as detection circuit 133 of power system 100 in Fig. 1. Circuit 200 is coupled to resistor 201 and structured to receive an electrical characteristic of resistor 201, determine whether a short circuit fault is occurring in a power system incorporating resistor 201 based on the received electrical characteristic, and output a fault trigger signal in response to determining a short circuit fault is occurring.

Circuit 200 includes a high bandwidth differential amplifier 215, a high speed comparator 227, and a signal latch 229, each of which are coupled to a low voltage power source 221 and a ground reference point 223. Low voltage power source 221 may output a voltage less than 10 V, to name but one example, and is structured to provide power to amplifier 215, comparator 227, and latch 229. In certain embodiments, one or more of amplifier 215, comparator 227, and latch 229 are coupled to different low voltage power sources.

Amplifier 215 includes a positive input terminal and a negative input terminal each coupled to resistor 201 such that amplifier 215 is coupled in parallel with resistor 201. Resistor 201 is coupled to the negative input terminal of amplifier 215 by way of a resistor 211 and coupled to the positive input terminal of amplifier 215 by way of resistor 213. The positive input terminal of amplifier 215 is also coupled to ground reference point 223 by way of resistor 214. The negative input terminal of amplifier 215 is also coupled to an output terminal of amplifier 215 by way of a resistor 219 and a capacitor 217 coupled in parallel between the negative input terminal and the output terminal. In certain embodiments, the resistances of the resistors 211, 213, 214, and 219 are each less than 10mOhm.

Amplifier 215 is structured to receive an input signal at the negative and positive input terminals, the input signal corresponding to an electrical characteristic of resistor 201, such as the voltage across resistor 201. Amplifier 215 is structured to amplify the magnitude of the input signal, generating an amplified signal which is output at the output terminal of amplifier 215. By amplifying the input signal, amplifier 215 increases the accuracy of detection circuit 200.

It is important to note that decoupling capacitor 109, resistance R₁₃₁, inductance L₁₃₁, and parasitic inductance 111 of Fig. 1 form an RLC circuit. Therefore, the high frequency loop 123 is structured to filter noise having a frequency greater than 1 MHz from amplifier 215. For example, high frequency noise may be caused by the switching of switches 117 and 119. Furthermore, resistor 219 and capacitor 217 form a low pass filter structured to further filter high frequency noise.

Comparator 227 is coupled to the output terminal of amplifier 215 and structured to receive the amplified signal from amplifier 215 at a positive input terminal of comparator 227. Comparator 227 is also coupled to a power source 226 at a negative input terminal of comparator 227 and structured to receive a voltage from power source 226 corresponding to a threshold voltage. The threshold voltage corresponds to a minimum voltage across resistor 201 which indicates a short circuit.

Comparator 227 is structured to compare the received amplified signal and the received threshold voltage and output a fault detection signal based on the comparison between the received amplified signal and the received threshold voltage. During normal operation of the monitored power system, the received amplified signal is smaller than the received threshold voltage, and comparator 227 is structured to output a low fault detection signal indicating no short circuit is detected. During a short circuit, the received amplified signal exceeds the received threshold voltage, and comparator 227 is structured to output a high fault detection signal indicating a short circuit fault has been detected.

In the illustrated circuit 200, latch 229 is a D flip-flop. In other embodiments, latch 229 may be another type of signal latch. Latch 229 includes a clock terminal CLK, an input terminal D, and an output terminal Q. Clock terminal CLK is coupled to the output terminal of comparator 227 and is structured to receive the fault detection signal from comparator 227. Input terminal D is structured to receive a constant high fault detection signal from a power source. Output terminal Q is structured to output a fault trigger signal. When latch 229 receives a high fault detection signal from comparator 227 indicating a short circuit fault has been detected, latch 229 outputs a fault trigger signal configured to cause gate driver circuits to respond to a detected short circuit fault.

In certain embodiments, detection circuit 200 is structured to detect a short circuit within 100ns of the beginning of the short circuit beginning. For example, detection circuit 200 may be structured to detect a short circuit within 50ns of the beginning of the short circuit. It shall be appreciated that any or all of the foregoing features of detection circuit 200 may also be present in the other detection circuits disclosed herein, such as detection circuit 133 of Fig. 1.

With reference to Fig. 3, there is a circuit diagram illustrating an exemplary gate driver circuit 300 coupled to a wide-bandgap switch 307. Gate driver circuit 300 is structured to turn on and turn off switch 307 based on a gate signal and a fault trigger signal. Switch 307 includes a gate terminal 301, a drain terminal 305, and a source terminal 303. Circuit 300 is coupled to gate terminal 301 and source terminal 303. Gate driver circuit 300 includes a digital isolator 306, an AND logic gate 319, a NOT logic gate 321, a gate driver integrated circuit 323, and a soft turn-off circuit 333.

Digital isolator 306 includes a primary side and a secondary side. A primary voltage source 311, a ground 315, and a gate signal source 309 are coupled to the primary side of digital isolator 306. A secondary voltage source 313, a ground reference 317, and an output terminal 314 are coupled to the secondary side of digital isolator 306. Digital isolator 306 is structured to receive a gate signal from gate signal source 309 by way of an input terminal 312 and output an isolated gate signal corresponding to the received gate signal from output terminal 314.

NOT logic gate 321 is structured to receive the fault trigger signal from an exemplary detection circuit, such as detection circuit 200 of Fig. 2, invert the received signal, and output the inverted signal. AND logic gate 319 is coupled to voltage source 313, ground reference 317, output terminal 314, and NOT logic gate 321. AND logic gate 319 is structured to receive the inverted signal from NOT logic gate 321 and the isolated gate signal from output terminal 314, and output a signal to gate driver integrated circuit 323 based on the received signals. For example, if the received isolated gate signal is a high value, indicating switch 307 should be turned on, and the fault trigger signal is a low value, indicating there is no short circuit, logic gate 319 will output a signal indicating switch 307 should be turned on. In another example, if the received isolated gate signals a high value, but the fault trigger signal is also a high value, indicating there is a short circuit, logic gate 319 will output a signal indicating switch 307 should be turned off or remain off.

Gate driver integrated circuit 323 is coupled to a power source 329, ground reference 317, and AND logic gate 319. Gate driver integrated circuit 323 includes a signal processor 327, a switch 325, and another switch 328. Gate driver integrated circuit 323 is structured to receive the signal output by logic gate 319, and generate an output signal using switches 325 and 328 based on the received signal. The output signal is output to gate terminal 301 of switch 307 by way of gate resistor 331.

Soft turn-off circuit 333 is coupled between gate terminal 301 and source terminal 303. Soft turn-off circuit 333 is structured to receive a fault trigger signal indicating a short circuit and, in response, modify the signal output by gate driver integrated circuit 323 so that switch 307 is turned off at a zero current crossing. In certain embodiments, soft turn-off circuit 333 is structured to increase a gate resistance in order to reduce voltage and current oscillations in the gate signal. It shall be appreciated that any or all of the foregoing features of gate driver circuit 300 may also be present in the other gate driver circuits disclosed herein, such as gate driver circuits 135 and 137 of Fig. 1.

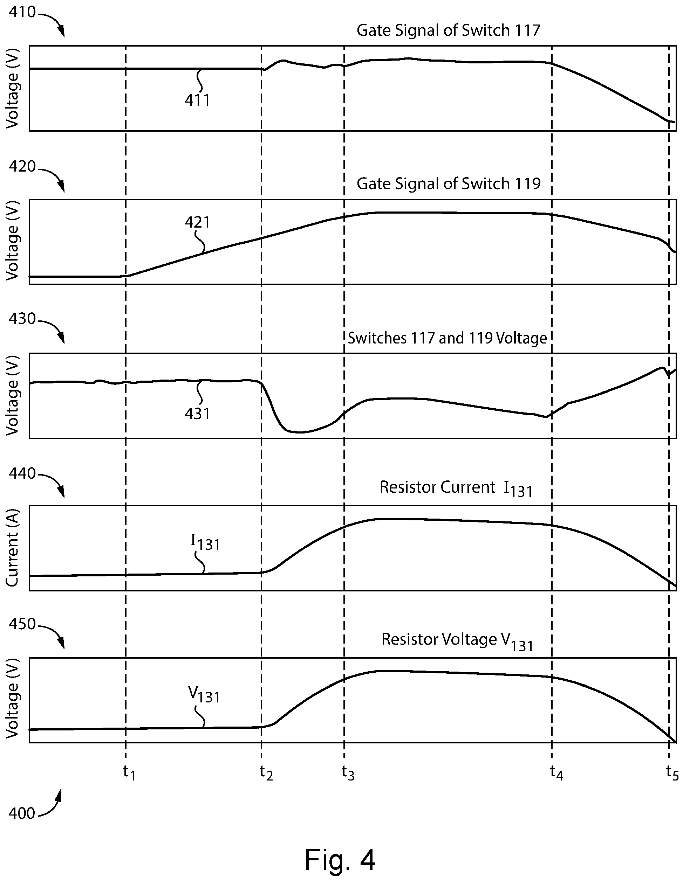

With reference to Fig. 4, there is illustrated a plurality of graphs 400 including graphs 410, 420, 430, 440, and 450. Graph 410 illustrates the magnitude of a gate voltage 411 applied to the gate of power switch 117. Graph 420 illustrates the magnitude of a gate voltage 421 applied to the gate of power switch 119. Graph 430 illustrates the magnitude of a voltage across switches 117 and 119 power device 105. Graph 440 illustrates the magnitude of current I₁₃₁ flowing through resistor 131. Graph 450 illustrates the magnitude of voltage V₁₃₁ across resistor 131.

Each graph illustrates electrical characteristics of power system 100 over a time period including time instants t₁-t₅. At time instant t₁, switch 119 experiences a failure, causing an increasing gate signal to be applied to the gate of switch 119. At time instant t₂, the gate signal applied to switch 119 closes switch 119 causing power system 100 to begin conducting a short circuit current. At time instant t₃, detection circuit 133 determines a short circuit is occurring based on Voltage V₁₃₁ exceeding a voltage threshold. At time instant t₄, gate driver circuits 135 and 137 stop transmitting gate signals to switches 117 and 119 in response to determining the short circuit is occurring. The gate signals decrease until time instant ts when system 130 causes the opening of switches 117 and 119 in response to determining the short circuit is occurring.

Further written description of a number of exemplary embodiments shall now be provided. One embodiment is a protection system for a power switch comprising: a resistor coupled in series with a decoupling capacitor; and a detection circuit structured to receive a voltage of the resistor, determine a short circuit is occurring based on the received voltage, and transmit a fault trigger signal in response to determining the short circuit is occurring.

In certain forms of the foregoing protection system, the protection system comprises a gate driver circuit structured to receive the fault trigger signal and turn off the power switch at a zero current crossing in response to receiving the fault trigger signal. In certain forms, the gate driver circuit includes a NOT logic gate structured to receive the fault trigger signal, an AND logic gate coupled to the NOT logic gate, and a soft turn-off circuit structured to receive the fault trigger signal. In certain forms, the resistor includes a printed circuit board trace arrangement having an equivalent resistance. In certain forms, the equivalent resistance is between 200 microohms and 10 milliohms. In certain forms, the detection circuit comprises: an amplifier structured to receive the resistor voltage; a comparator structured to receive an amplified output from the amplifier and a short circuit voltage threshold; and a signal latch structured to receive a fault detection signal from the comparator and output the fault trigger signal to a gate driver circuit. In certain forms, the short circuit voltage threshold corresponds to a first resistor voltage greater than a second resistor voltage generated by a toggling of the power switch. In certain forms, the power switch is a wide-bandgap switch, wherein the detection circuit is structured to transmit the fault trigger signal within 50ns of a beginning of the short circuit, and wherein the fault trigger signal is configured to cause a gate driver to turn off the power switch. In certain forms, the detection circuit is structured to determine the short circuit is occurring by amplifying the received voltage, comparing the amplified voltage to a short circuit voltage threshold, and determining the amplified voltage is greater than the short circuit voltage threshold, wherein the short circuit voltage threshold is greater than a first resistor voltage generated by a current flowing through the decoupling capacitor during toggling of the power switch. In certain forms, the voltage across the resistor is generated by a high frequency current flowing through the decoupling capacitor.

Another exemplary embodiment is a method for protecting a power switch comprising: receiving, with a detection circuit, a voltage of a resistor coupled in series with a decoupling capacitor; determining, with the detection circuit, a short circuit is occurring based on the received voltage; and transmitting, with the detection circuit, a fault trigger signal in response to determining the short circuit is occurring.

In certain forms of the foregoing method, the method comprises receiving, with a gate driver circuit, the fault trigger signal; and turning off, with the gate driver circuit, the power switch at a zero current crossing in response to receiving the fault trigger signal. In certain forms, receiving the fault trigger signal includes receiving the fault trigger signal with a NOT logic gate of the gate driver circuit and receiving the fault trigger signal with a soft turn-off circuit of the gate driver circuit, and wherein the method comprises receiving, with an AND logic gate, an inverted signal of the fault trigger signal from the NOT logic gate. In certain forms, the resistor includes a printed circuit board trace arrangement having an equivalent resistance. In certain forms, the equivalent resistance is between 200 microohms and 10 milliohms. In certain forms, the method comprises receiving, with a comparator of the detection circuit, an amplified output from an amplifier and a short circuit voltage threshold; receiving, with a signal latch, a fault detection signal from the comparator; and outputting, with the signal latch, the fault trigger signal to a gate driver circuit. In certain forms, the short circuit voltage threshold corresponds to a first resistor voltage greater than a second resistor voltage generated by a toggling of the power switch. In certain forms, the power switch is a wide-bandgap switch, wherein transmitting, with the detection circuit, the fault trigger signal occurs within 50ns of a beginning of the short circuit, and wherein the fault trigger signal is configured to cause a gate driver to turn off the power switch. In certain forms, determining the short circuit is occurring includes: amplifying the received voltage; comparing the amplified voltage to a short circuit voltage threshold; and determining the amplified voltage is greater than the short circuit voltage threshold, wherein the short circuit voltage threshold is based on a first resistor voltage generated by a current flowing through the decoupling capacitor during toggling of the power switch. In certain forms, the voltage is generated by a high frequency current flowing through the decoupling capacitor.

While the present disclosure has been illustrated and described in detail in the drawings and foregoing description, the same is to be considered as illustrative and not restrictive in character, it being understood that only certain exemplary embodiments have been shown and described, and that all changes and modifications that come within the spirit of the present disclosure are desired to be protected. It should be understood that while the use of words such as "preferable," "preferably," "preferred" or "more preferred" utilized in the description above indicate that the feature so described may be more desirable, it nonetheless may not be necessary, and embodiments lacking the same may be contemplated as within the scope of the present disclosure, the scope being defined by the claims that follow. In reading the claims, it is intended that when words such as "a," "an," "at least one," or "at least one portion" are used there is no intention to limit the claim to only one item unless specifically stated to the contrary in the claim. The term "of' may connote an association with, or a connection to, another item, as well as a belonging to, or a connection with, the other item as informed by the context in which it is used. The terms "coupled to," "coupled with" and the like include indirect connection and coupling, and further include but do not require a direct coupling or connection unless expressly indicated to the contrary. When the language "at least a portion" and/or "a portion" is used, the item can include a portion and/or the entire item unless specifically stated to the contrary.

## Claims

1. A protection system for a power switch comprising:
a resistor coupled in series with a decoupling capacitor; and
a detection circuit structured to receive a voltage of the resistor, determine a short circuit is occurring based on the received voltage, and transmit a fault trigger signal in response to determining the short circuit is occurring.

2. The protection system of claim 1, comprising:
a gate driver circuit structured to receive the fault trigger signal and turn off the power switch at a zero current crossing in response to receiving the fault trigger signal.

3. The protection system of claim 2, wherein the gate driver circuit includes a NOT logic gate structured to receive the fault trigger signal, an AND logic gate coupled to the NOT logic gate, and a soft turn-off circuit structured to receive the fault trigger signal.

4. The protection system of claim 1, wherein the resistor includes a printed circuit board trace arrangement having an equivalent resistance, preferably, wherein the equivalent resistance is between 200 microohms and 10 milliohms.

5. The protection system of claim 1, wherein the detection circuit comprises:
an amplifier structured to receive the resistor voltage;
a comparator structured to receive an amplified output from the amplifier and a short circuit voltage threshold, preferably wherein the short circuit voltage threshold corresponds to a first resistor voltage greater than a second resistor voltage generated by a toggling of the power switch; and
a signal latch structured to receive a fault detection signal from the comparator and output the fault trigger signal to a gate driver circuit.

6. The protection system of claim 1, wherein the power switch is a wide-bandgap switch, wherein the detection circuit is structured to transmit the fault trigger signal within 50ns of a beginning of the short circuit, and wherein the fault trigger signal is configured to cause a gate driver to turn off the power switch.

7. The protection system of claim 1, wherein the detection circuit is structured to determine the short circuit is occurring by amplifying the received voltage, comparing the amplified voltage to a short circuit voltage threshold, and determining the amplified voltage is greater than the short circuit voltage threshold, wherein the short circuit voltage threshold is greater than a first resistor voltage generated by a current flowing through the decoupling capacitor during toggling of the power switch.

8. The protection system of claim 1, wherein the voltage across the resistor is generated by a high frequency current flowing through the decoupling capacitor.

9. A method for protecting a power switch comprising:
receiving, with a detection circuit, a voltage of a resistor coupled in series with a decoupling capacitor;
determining, with the detection circuit, a short circuit is occurring based on the received voltage; and
transmitting, with the detection circuit, a fault trigger signal in response to determining the short circuit is occurring.

10. The method of claim 9 comprising:
receiving, with a gate driver circuit, the fault trigger signal; and
turning off, with the gate driver circuit, the power switch at a zero current crossing in response to receiving the fault trigger signal.

11. The method of claim 10, wherein receiving the fault trigger signal includes receiving the fault trigger signal with a NOT logic gate of the gate driver circuit and receiving the fault trigger signal with a soft turn-off circuit of the gate driver circuit, and wherein the method comprises receiving, with an AND logic gate, an inverted signal of the fault trigger signal from the NOT logic gate.

12. The method of claim 9, wherein the resistor includes a printed circuit board trace arrangement having an equivalent resistance; or
wherein the equivalent resistance is between 200 microohms and 10 milliohms.

13. The method of claim 9, comprising:
receiving, with a comparator of the detection circuit, an amplified output from an amplifier and a short circuit voltage threshold;
receiving, with a signal latch, a fault detection signal from the comparator; and
outputting, with the signal latch, the fault trigger signal to a gate driver circuit.

14. The method of claim 13, wherein the short circuit voltage threshold corresponds to a first resistor voltage greater than a second resistor voltage generated by a toggling of the power switch.

15. The method of claim 9, wherein the power switch is a wide-bandgap switch, wherein transmitting, with the detection circuit, the fault trigger signal occurs within 50ns of a beginning of the short circuit, and wherein the fault trigger signal is configured to cause a gate driver to turn off the power switch; or
wherein determining the short circuit is occurring includes:
amplifying the received voltage;
comparing the amplified voltage to a short circuit voltage threshold; and
determining the amplified voltage is greater than the short circuit voltage threshold,
wherein the short circuit voltage threshold is based on a first resistor voltage generated by a current flowing through the decoupling capacitor during toggling of the power switch; or
wherein the voltage is generated by a high frequency current flowing through the decoupling capacitor.
